# EUROPEAN PATENT APPLICATION

(11) **EP 2 763 516 A2**
(43) Date of publication of application: **06.08.2014**
(21) Application number: 13184175.1
(22) Date of filing: 12.09.2013
(51) Int. Cl.: H05K 3/34

(54) **Light-emitting device and lighting apparatus**

(30) Priority: 01.02.2013 JP 2013018991
(71) Applicant: Toshiba Lighting & Technology Corporation, Yokosuka-shi, Kanagawa 237-8510 (JP)
(72) Inventor: Honma, Takuya, Kanagawa, 237-8510 (JP)
(74) Representative: Bokinge, Ole

(57) **Abstract**

According to one embodiment, a light-emitting device (110) includes a ceramic substrate (10), a light-emitting element (20), a metal layer (51, 52), a metal connector (40) and a joint member (61, 62). The ceramic substrate (10) includes a main surface (10u). The light-emitting element (20) is provided on the main surface (10u). The metal layer (51, 52) is provided on the main surface (10u) and is electrically connected to the light-emitting element (20). The metal connector (40) includes a connector part (43) and an extension part (41, 42) extending from the connector part (43). The joint member (61, 62) joins at least a part of the extension part (41, 42) to the metal layer (51, 52). An angle (θ1) between a lower portion (61sl) of a side surface (61s) of the joint member (61, 62) on the connector part (43) side and a lower surface (611) of the joint member (61, 62) in contact with the metal layer (51, 52) is 90 degrees or less. A portion, which has a thickness of 2/3 or more of a thickness (T1) of the extension part (41, 42), of an end part (41e) of the extension part (41, 42) on an opposite side to the connector part (43) is covered with the joint member (61, 62).

## Description

### FIELD

Embodiments described herein relates generally to a light-emitting device and a lighting apparatus.

### BACKGROUND

For example, there is a light-emitting device including a semiconductor light-emitting element and a wiring substrate on which the semiconductor light-emitting element is mounted. The light-emitting device as stated above is used for, for example, a lighting apparatus such as a floodlight. It is desired that the output of the light-emitting device is increased and the light amount is increased. In accordance this, heat load to a member included in the light-emitting device increases. For example, in addition to temperature load at the time of lighting, heat shock at the time of blinking also increases. Particularly, the heat load increases in a joint member, such as solder, used in the light-emitting device, and this causes reliability to be deteriorated.

### BRIEF DESCRIPTION OF THE DRAWINGS

FIG. 1A to FIG. 1D are schematic views exemplifying a light-emitting device of a first embodiment.
FIG. 2 is a schematic sectional view exemplifying the light-emitting device of the first embodiment.
FIG. 3 is a schematic sectional view exemplifying the light-emitting device of the first embodiment.
FIG. 4A to FIG. 4D are schematic sectional views exemplifying light-emitting devices of reference examples.
FIG. 5 is a schematic sectional view exemplifying a light-emitting device of a second embodiment.
FIG. 6 is a schematic sectional view exemplifying a light-emitting device of a third embodiment.
FIG. 7 is a schematic sectional view exemplifying a light-emitting device of a fourth embodiment.
FIG. 8 is a schematic sectional view exemplifying a lighting apparatus of a fifth embodiment.

### DETAILED DESCRIPTION

In general, according to one embodiment, a light-emitting device includes a ceramic substrate, a light-emitting element, a first metal layer, a second metal layer, a metal connector, a first joint member and a second joint member. The ceramic substrate includes a main surface. The light-emitting element is provided on the main surface. The first metal layer is provided on the main surface and is electrically connected to the light-emitting element. The second metal layer is separated from the first metal layer on the main surface and is electrically connected to the first metal layer. The metal connector includes a connector part which is provided over the main surface and is separated from the main surface, and is connected to a wiring through which current supplied to the light-emitting element flows, a first extension part which extends from one end of the connector part and at least a part of which is provided on the first metal layer, and a second extension part which extends from the other end of the connector part and at least a part of which is provided on the second metal layer. The first joint member joins at least the part of the first extension part to the first metal layer. The second joint member joins at least the part of the second extension part to the second metal layer. An angle between a lower portion of a side surface of the first joint member on the connector part side and a lower surface of the first joint member in contact with the first metal layer is 90 degrees or less. A portion, which has a thickness of 2/3 or more of a thickness of the first extension part, of a first end part of the first extension part on an opposite side to the connector part is covered with the first joint member.

According to another embodiment, a lighting apparatus includes a light-emitting device that includes a ceramic substrate including a main surface, a light-emitting element provided on the main surface, a first metal layer provided on the main surface and electrically connected to the light-emitting element, a second metal layer separated from the first metal layer on the main surface and electrically connected to the first metal layer, a metal connector including a connector part which is provided over the main surface and is separated from the main surface, and is connected to a wiring through which current supplied to the light-emitting element flows, a first extension part which extends from one end of the connector part and at least a part of which is provided on the first metal layer, and a second extension part which extends from the other end of the connector part and at least a part of which is provided on the second metal layer, a first joint member to join at least the part of the first extension part to the first metal layer, and a second joint member to join at least the part of the second extension part to the second metal layer, wherein an angle between a lower portion of a side surface of the first joint member on the connector part side and a lower surface of the first joint member in contact with the first metal layer is 90 degrees or less, and a portion, which has a thickness of 2/3 or more of a thickness of the first extension part, of a first end part of the first extension part on an opposite side to the connector part is covered with the first joint member, and a base body connected to the ceramic substrate.

Hereinafter, exemplary embodiments will be described with reference to the drawings.

Incidentally, the drawings are schematic or conceptual. A relation between thickness and width of each portion and a ratio of sizes of portions are not necessarily the same as actual ones. Besides, even when the same portion is shown, there is a case where the size and ratio are shown to be different between the drawings.

Incidentally, in the specification and the drawings, the same components as those already described in an already mentioned drawing are denoted by the same reference numerals and detailed explanation thereof is appropriately omitted.

### First Embodiment

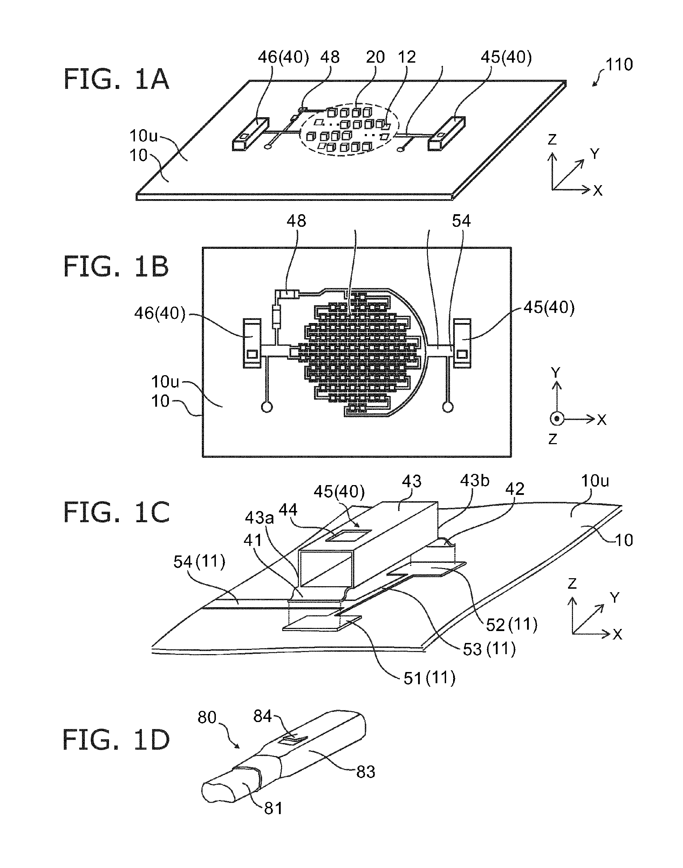

FIG. 1A to FIG. 1D are schematic views exemplifying a light-emitting device of a first embodiment. FIG. 1A is a schematic perspective view. FIG. 1B is a schematic plan view exemplifying a part of the light-emitting device. FIG. 1C is a schematic perspective view in which a portion of a metal connector included in the light-emitting device is enlarged. FIG. 1D is a schematic perspective view exemplifying a wiring used in the light-emitting device.

As shown in FIG. 1A, a light-emitting device 110 of this embodiment includes a ceramic substrate 10, a light-emitting element 20, a metal film 11 and a metal connector 40.

The ceramic substrate 10 includes a main surface 10u. The main surface 10u is an upper surface of the ceramic substrate 10.

A direction perpendicular to the main surface 10u of the ceramic substrate 10 is a Z-axis direction. One of directions perpendicular to the Z-axis direction is an X-axis direction. A direction perpendicular to the Z-axis direction and the X-axis direction is a Y-axis direction.

As shown in FIG. 1B, in this example, the plane shape of the ceramic substrate 10 is substantially rectangular. In this example, an extension direction of one side of the ceramic substrate 10 corresponds to the X-axis direction, and an extension direction of the other side corresponds to the Y-axis direction. In this embodiment, the relation between the side and the axial direction is arbitrary. Further, in this embodiment, the plane shape of the ceramic substrate 10 is arbitrary.

The light-emitting element 20 is provided on the main surface 10u of the ceramic substrate 10. A semiconductor light-emitting element (for example, an LED) or the like is used as the light-emitting element 20. In this example, in order to obtain high light output, the plural light-emitting elements 20 are provided. In FIG. 1B, the light-emitting elements 20 are omitted in order to make the drawing easy to see.

For example, a copper layer is used as the metal film 11. A laminate film including a nickel layer, a gold layer provided on the nickel layer and a palladium layer provided on the metal layer may be further provided on the copper layer. According to this structure, high conductivity and high light reflectivity can be obtained. Light loss can be suppressed and high efficiency can be obtained. Further, high corrosion resistance and high reliability can be obtained.

The metal film 11 includes plural pattern parts 12. The light-emitting elements 20 are arranged on part of the plural pattern parts 12.

In the specification, a state of being provided on something includes a state of being provided in direction contact with something and a state where another element (including a space) intervenes.

The metal connector 40 is provided on at least a part of any other one of the plural pattern parts 12. In this example, the two metal connectors 40 are provided. That is, the metal connectors 40 are provided on the main surface 10u of the ceramic substrate 10.

As the two metal connector 40, a first metal connector 45 and a second metal connector 46 are provided. For example, the first metal connector 45 is one of an anode side connector and a cathode side connector. The second metal connector 46 is the other of the anode side connector and the cathode side connector.

In this example, an electric component 48 is further provided. The electric component 48 is arranged on any one of the plural pattern parts 12 of the metal film 11. The electric part 48 is, for example, a capacitor.

For example, a wiring is connected to the first metal connector 45 and the second metal connector 46, and current is supplied to the light-emitting elements 20 through the metal film 11. Thereby, light is emitted from the light-emitting elements 20.

Since the structure of the second metal connector 46 is similar to the structure of the first metal connector 45, the first connector 45 will be described below.

As shown in FIG. 1C, a first metal layer 51 and a second metal layer 52 are provided on the main surface 10u of the ceramic substrate 10. These metal layers are part of the metal film 11 (pattern parts 12).

The first metal layer 51 is electrically connected to the light-emitting elements 20. For example, a wiring pattern 54 connected to the light-emitting elements 20 is connected to the first metal layer 51. The wiring pattern 54 is a part of the metal film 11.

In the specification, an electrically connected state includes a state where two conductors physically contact each other, a state where two conductors are connected through another conductor, and a state where an electric element (for example, the electric component 48) is provided between two conductors and current can flow between the two conductors through the electric element. The electric element (the electric component 48, etc.) includes, for example, a capacitor, a resistor, an inductor, a switching element and a diode (including a semiconductor light-emitting element).

The second metal layer 52 is separated from the first metal layer 51 on the main surface 10u of the ceramic substrate 10. The second metal layer 52 is electrically connected to the first metal layer 51. In this example, the first metal layer 51 and the second metal layer 52 are electrically connected through an intermediate wiring pattern 53. The intermediate wiring pattern 53 is a part of the metal film 11.

In this example, a direction directed from the first metal layer 51 to the second metal layer 52 is the Y-axis direction. The width of the first metal layer 51 in the X-axis direction and the width of the second metal layer 52 in the X-axis direction are respectively wider than the width of the intermediate wiring pattern 53 in the X-axis direction.

At least a part of the first metal connector 45 is disposed on the first metal layer 51 and the second metal layer 52.

In FIG. 1C, in order to make the drawing easy to see, the first metal connector 45 is shown to be separated from the first metal layer 51 and the second metal layer 52.

As shown in FIG. 1C, the first metal connector 45 (the metal connector 40) includes a connector part 43, a first extension part 41 and a second extension part 42.

The connector part 43 is provided over the main surface 10u of the ceramic substrate 10. The connector part 43 is separated from the main surface 10u. The connector part 43 is connected to a wiring through which current supplied to the light-emitting elements 20 flows. In this example, an opening 44 is provided in the upper surface of the connector part 43.

The first extension part 41 extends from one end 43a of the connector part 43. At least a part of the first extension part 41 is provided on the first metal layer 51. The second extension part 42 extends from the other end 43b of the connector part 43. At least a part of the second extension part 42 is provided on the second metal layer 52.

Metal is used for the connector part 43, the first extension part 41 and the second extension part 42. For example, an alloy containing iron and chromium is used as the metal. The metal may further contain nickel. For example, stainless steel is used for the first metal connector 45 (the metal connector 40).

FIG. 1D exemplifies a wiring 80 through which current supplied to the light-emitting elements 20 flows.

As shown in FIG. 1D, the wiring 80 includes a wire 81 and an insertion terminal 83 provided on a tip of the wire 81. A projection 84 is provided on a side surface of the insertion terminal 83. The insertion terminal 83 is inserted in the connector part 43 of the first metal connector 45. The connector part 43 includes a space in which the insertion terminal 83 is inserted. In the state where the insertion terminal 83 is inserted in the connector part 43, the projection 84 of the insertion terminal 83 is engaged with the opening 44 of the connector part 43. Thereby, falling off is suppressed.

Connection between the first metal layer 51 and the first extension part 41 and connection between the second metal layer 52 and the second extension part 42 are performed by, for example, soldering.

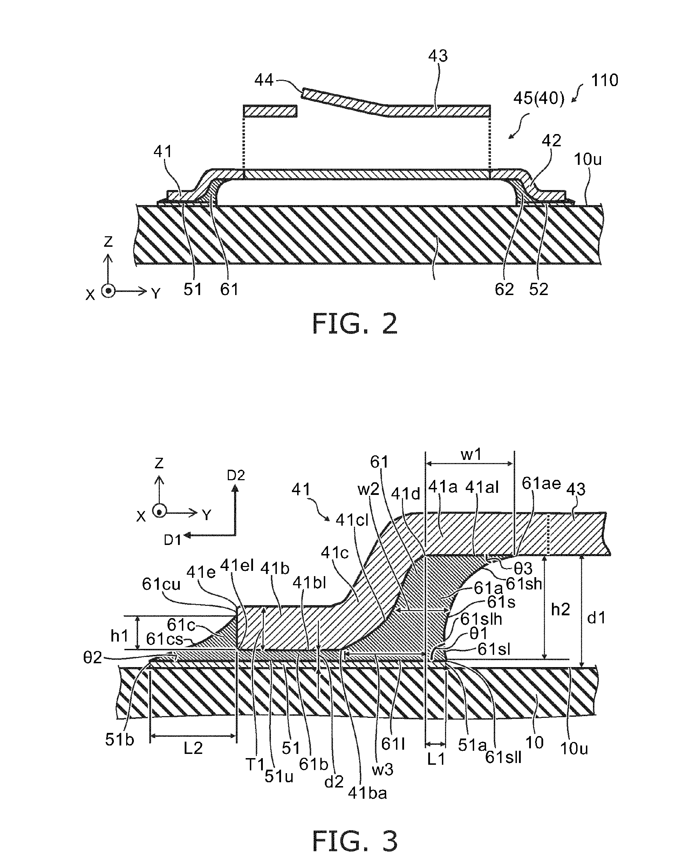

FIG. 2 is a schematic sectional view exemplifying the light-emitting device of the first embodiment.

FIG. 2 is the schematic sectional view in which a portion of the metal connector 40 (the first metal connector 45) is enlarged.

At least a part of the first extension part 41 is provided on the first metal layer 51, and at least a part of the second extension part 42 is provided on the second metal layer 52.

The light-emitting device 110 is further provided with a first joint member 61 and a second joint member 62. For example, solder is used as these joint members.

The first joint member 61 joins at least the part of the first extension part 41 to the first metal layer 51. The second joint member 62 joins at last the part of the second extension part 42 to the second metal layer 52.

The first metal connector 45 is fixed to the main surface 10u of the ceramic substrate 10 by the first extension part 41 and the second extension part 42. On the other hand, the connector part 43 is separated from the main surface 10u. A space is formed between the connector part 43 and the main surface 10u. By this, even in the case where stress is applied to the first metal connector 45 by heat generated at the time of operation, the stress is relieved and excellent joining of the first metal connector 45 can be maintained.

Hereinafter, with respect to the light-emitting device 110 of this embodiment, an example of a joining state of the first extension part 41 will be described. The following description on the first extension part 41 can be applied also to the second extension part 42.

FIG. 3 is a schematic sectional view exemplifying the light-emitting device of the first embodiment.

FIG. 3 is the schematic sectional view in which a portion of the first extension part 41 of the first metal connector 45 is enlarged.

As shown in FIG. 3, for example, the first extension part 41 extends from the connector part 43 substantially in parallel to the X-Y plane, and then is bent downward. Thereafter, the first extension part extends substantially in parallel to the X-Y plane, and reaches a first end part 41e. The first extension part 41 having the shape as stated above is connected to the first metal layer 51 by the first joint member 61.

The first joint member 61 includes a side surface 61s on the connector part 43 side. Further, the first joint member 61 includes a lower surface 61l in contact with the first metal layer 51.

In this embodiment, an angle (first angle θ1) between a lower portion 61sl of the side surface 61s of the first joint member 61 on the connector part 43 side and the lower surface 61l of the first joint member 61 in contact with the first metal layer 51 is 90 degrees or less. For example, the lower portion 61sl of the side surface 61s of the first joint member 61 has a forward tapered shape.

As exemplified in FIG. 3, in this example, the side surface 61s of the first joint member 61 on the connector part 43 side has a curved shape. At this time, the inclination of the side surface 61s changes according to the distance from the first metal layer 51. In this embodiment, a height of an upper end 61slh of the lower portion 61sl of the side surface 61s from an upper surface 51u (that is, the lower surface 61l of the first joint member 61) of the first metal layer 51 is 1/5 of a length (second height h2 described later) of the side surface 61s in the Z-axis direction.

On the other hand, a sectional shape of a portion where the side surface 61s contacts the first metal layer 51 can be microscopically unstable. In this embodiment, a height of a lower end 61sll of the lower portion 61sl of the side surface 61s from the upper surface 51u of the first metal layer 51 is 1/50 of the length (the second height h2) of the side surface 61s in the Z-axis direction.

Also when the inclination of the side surface 61s changes between the upper end 61slh and the lower end 61sll of the lower portion 61sl of the side surface 61s, the first angle θ1 relative to the lower surface 61l can be defined at each position of the side surface 61s. The first angle θ1 at each position is 90 degrees or less. For convenience, an average of angles between the side surface 61s and the lower surface 61l at the respective positions of the side surface 61s may be used as the first angle θ1.

Since the first angle θ1 is made 90 degrees or less, peeling between the lower surface 61l of the first joint member 61 and the upper surface 51u of the first metal layer 51 can be suppressed.

On the other hand, the first extension part 41 includes the first end part 41e on the opposite side to the connector part 43. In the first end part 41e, a portion of the first end part 41e, which has a thickness of 2/3 or more of a thickness T1 of the first extension part 41, is covered with the first joint member 61. The thickness of the first end part 41e is substantially equal to the thickness T1 of the first extension part 41. That is, the portion having the thickness of 2/3 or more of the thickness of the first end part 41e is covered with the first joint member 61. For example, all the first end part 41e in the thickness direction may be covered with the first joint member 61.

For example, the first joint member 61 includes an upper end 61cu in contact with the first end part 41e of the first extension part 41. The height of the upper end 61cu is equal to or higher than the position of 2/3 of the thickness T1 of the first extension part 41 from a lower end part 41el of the first end part 41e. For example, a distance (distance in the Z-axis direction and a first height h1) between the upper end 61cu of the first joint member 61 in contact with the first end part 41e and the upper surface 51u of the first metal layer 51 is equal to or larger than a distance (distance in the Z-axis direction) between the position of 2/3 of the thickness T1 of the first extension part 41 from the lower end part 41el of the first end part 41e and the upper surface 51u of the first metal layer 51.

Since the portion of the first end part 41e, which has the thickness of 2/3 or more, is covered with the first joint member 61, joining between the first end part 41e and the first metal layer 51 by the first joint member 61 becomes firm, and high reliability can be obtained.

In this embodiment, the amount of heat generated at high output is large and the heat load becomes high. In this embodiment, also at this time, high joining reliability of the joint member is obtained. Since the strength of the joint portion is high, also when a large stress occurs by heat, deterioration of the joint portion can be suppressed. Especially, when the light-emitting device is blinked, a large heat shock is applied to the joint portion. Also at this time, the high reliability can be maintained. In this embodiment, the shape (that is, the shape based on wettability) of the solder to join the joint portion (extension part) of the metal connector 40 to the metal layer is regulated to the specific shape. By this, the heat stress can be reduced and the mechanical strength can be improved.

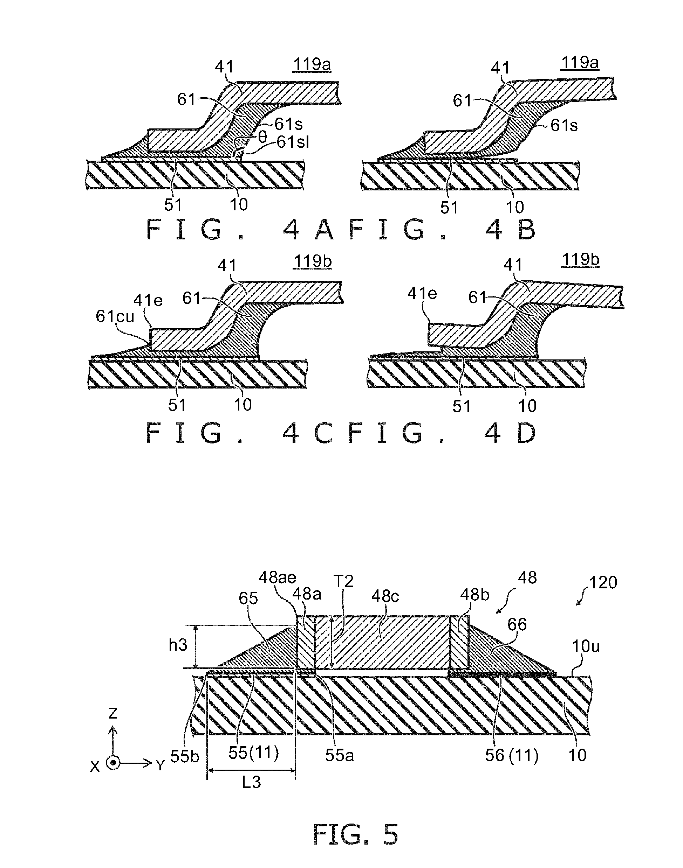

FIG. 4A to FIG. 4D are schematic sectional views exemplifying light-emitting devices of reference examples.

These drawings show joint states of the first extension part 41.

As exemplified in FIG. 4A, in a light-emitting device 119a of a first reference example, in a lower portion 61sl of a side surface 61s of a first joint member 61 on a connector part 43 side, a first angle θ1 exceeds 90 degrees. That is, the lower portion 61s1 of the side surface 61s has a reverse-tapered shape.

Thus, as exemplified in FIG. 4B, in the side surface 61s on the connector part 43 side, the lower surface 61l of the first joint member 61 is liable to be peeled from the upper surface 51u of the first metal layer 51. This phenomenon is liable to occur especially when the amount of heat generated at high output is large and heat load is high. Besides, the phenomenon is liable to occur especially when the light-emitting device is blinked and large heat shock is applied.

On the other hand, as exemplified in FIG. 4C, in a light-emitting device 119b of a second reference example, a height of a portion of a first end part 41e of a first extension part 41, which is covered with a first joint member 61, is less than 2/3 of a thickness of the first extension part 41.

Thus, as exemplified in FIG. 4D, on the first end part 41e side, a lower surface 61l of the first joint member 61 is liable to be peeled from an upper surface 51u of a first metal layer 51. This phenomenon is liable to occur especially when the amount of heat generated at high output is large and heat load is high. Besides, the phenomenon is liable to occur especially when the light-emitting device is blinked and large heat shock is applied. Especially, the phenomenon is liable to occur when a mechanical force is applied to the first metal connector 45 during the work of connecting a wiring 80 to the first metal connector 45, and when damage occurs in the first joint member 61 or an interface portion of the first joint member 61 by the force.

The inventor formed samples (light-emitting devices) in which with respect to various shapes of the first metal layer 51 and the first extension part 41, the amount of material (for example, solder) of the first joint member 61 and forming conditions (for example, soldering temperature and time, and connector suppressing load) were changed, and the first angle θ1 and the height of the portion of the first end part 41e covered with the first joint member 61 were changed. With respect to the samples, operation and blinking tests were performed. In the tests, heat shock was applied. From the results of the tests as stated above, it was found that if the first angle θ1 was 90 degrees or less and the height of the portion of the first end part 41e covered with the first joint member 61 was 2/3 or more of the thickness of the first extension part 41, excellent joining was obtained. The foregoing structure described in this embodiment is based on the experimental results.

The light-emitting device 110 of the embodiment is a high-output light-emitting device. In this embodiment, luminous emittance is, for example, 10 lm/mm² or more. Incidentally, the luminous emittance is a value obtained by dividing the luminous flux (Im) obtained as the light amount of the light-emitting device by the area of the emitted light of the light-emitting device. The area of the emitted light corresponds to, for example, the sum total (mm²) of areas of light-outgoing surfaces of a wavelength conversion layer made of resin containing phosphor and formed so as to cover the plural light-emitting elements 20. In the high-output light-emitting device, the amount of generated heat is large, and heat load is high. Thus, in order to obtain high thermal radiation property, the ceramic substrate 10 is used as the substrate on which the light-emitting elements 20 are mounted. Thereby, the high thermal radiation property and excellent insulation property are obtained. Further, the metal connector 40 is used as the connector provided on the ceramic substrate 10. If the connector containing, for example, resin is used as the connector, the resin is deteriorated by the intense light emitted from the light-emitting elements 20. In this embodiment, since the metal connector is used, even if the intense light is irradiated, deterioration does not substantially occur.

For example, if the connector using resin is used, even if stress occurs, the stress is easily relieved by the softness of the resin. On the other hand, in the metal connector especially used in the high-output light-emitting device as in this embodiment, large stress is liable to be applied to the metal connector as compared with the resin connector. In the state where the large stress is applied, high temperature and heat shock are applied to the joint member to join the metal connector 40 to the metal layer by operation and blinking.

Also in the specific condition in the high-output light-emitting device, it is required that stable joining is maintained and high reliability is realized. The new problem as described above can be solved by this embodiment. In the embodiment, the first angle θ1 is 90 degrees or less, and the height of the portion of the first end part 41e covered with the first joint member 61 is 2/3 or more of the thickness of the first extension part 41. As a result, the high-output and highly reliable light-emitting device can be provided.

In this embodiment, the metal connector 40 (the first metal connector 45) has a unique structure. That is, the connector part 43, the first extension part 41 extending from the connector part 43 and the second extension part 42 are provided. These extension parts are joined to the metal layer, and the connector part 43 is provided over the ceramic substrate 10 and is fixed to be separated from the ceramic substrate 10. By this, also when the temperature of the metal connector 40 rises at the time of operation, for example, stress due to difference in thermal expansion coefficient between the metal connector 40 and the metal layer (or the ceramic substrate 10) is easily relived. Especially, even when large heat shock occurs at the time of blinking, stress is suppressed and stable joining can be easily maintained.

The example of the structure of the extension part 41 will be further described.

As shown in FIG. 3, the first extension part 41 includes a first portion 41a, a second portion 41b, a third portion 41c and a boundary 41d in addition to the first end part 41e.

As described before, the first end part 41e is the end on the opposite side to the connector part 43. The first portion 41a is provided between the first end part 41e and the connector part 43. The first portion 41a is connected to the connector part 43. A distance between the first portion 41a and the main surface 10u of the ceramic substrate 10 is a first distance d1. The first distance d1 is the distance between a lower surface 41al of the first portion 41a and the main surface 10u in the Z-axis direction. For example, the first distance d1 substantially corresponds to a distance between the connector part 43 and the main surface 10u.

The second portion 41b is provided between the first end part 41e and the first portion 41a. A distance between the second portion 41b and the main surface 10u is a second distance d2. The second distance d2 is shorter than the first distance d1. That is, the second portion 41b is positioned below the first portion 41a.

The third portion 41c is provided between the first portion 41a and the second portion 41b. The third portion 41c connects the first portion 41a and the second portion 41b.

The boundary 41d is a portion between the first portion 41a and the third portion 41c.

The second portion 41b extends substantially in parallel to the X-Y plane. In this example, the first portion 41a also extends substantially in parallel to the X-Y plane. The third portion 41c is inclined relative to the X-Y plane. An angle between the plane (X-Y plane) parallel to the main surface 10u and an extension direction of the first portion 41a is a first angle. An angle between the plane (X-Y plane) and an extension direction of the second portion 41b is a second angle. An angle between the plane (X-Y plane) and an extension direction of the third portion 41c is a third angle. The third angle is larger than the first angle and larger than the second angle. For example, the first angle is less than 20 degrees, and the second angle is also less than 20 degrees. On the other hand, the third angle is, for example, 20 degrees or more. That is, the third portion 41c is a bent portion.

The first portion 41a is the portion connected to the connector part 43. In this example, the first portion extends substantially in parallel to the extension direction of the connector part 43. Since the first portion 41a is substantially parallel to the X-Y plane, the connector part 43 is also parallel to the X-Y plane. Since the connector part 43 is disposed substantially in parallel to the X-Y plane, the connector part 43 is disposed over the main surface 10u in the stable state by the first extension part 41 and the second extension part 42. The first portion 41a may extend in a direction crossing the X-Y plane.

The second portion 41b is the portion disposed over the first metal layer 51 provided on the main surface 10u. Since the second portion 41b is substantially parallel to the X-Y plane, joining intensity by the first joint member 61 in the second portion 41b becomes high.

The connector part 43 is provided over the main surface 10u and is separated from the main surface 10u by the long distance (first distance d1) from the main surface 10u. On the other hand, the second portion 41b connected to the first metal layer 51 provided on the main surface 10u is disposed below the first portion 41a. The first portion 41a and the second portion 41b are connected by the third portion 41c.

By the structure as stated above, stress due to difference in thermal expansion coefficient between the first metal connector 45 and the first metal layer 51 (and the ceramic substrate 10) can be easily relieved. Especially, even when large heat shock occurs at the time of blinking, the stress is suppressed and stable joining can be easily maintained.

In this example, the first portion 41a, the second portion 41b and the third portion 41c are formed by bending one metal plate. The thickness (thickness in the Z-axis direction) of the first portion 41a is substantially equal to the thickness (thickness in the Z-axis direction) of the second portion 41b. For example, the thickness of the first portion 41a is 0.8 times or more and 1.2 times or less the thickness of the second portion 41b. The thickness of the third portion 41c (thickness of the third portion 41c in a direction perpendicular to the extension direction) is equal to the thickness of the second portion 41b.

Hereinafter, with respect to the first extension part 41 and the first metal layer 51, an example of a positional relation in the Y-axis direction will be described. The Y-axis direction is the direction directed from the first metal layer 51 to the second metal layer 52. The Y-axis direction corresponds to the direction directed from the first extension part 41 to the second extension part 42.

When projected on the X-Y plane, the second portion 41b and the third portion 41c overlap the first metal layer 51. For example, when projected on the X-Y plane, the first metal layer 51 includes a first metal layer end 51a on the connector part 43 side and a second metal layer end 51b on the opposite side to the first metal layer end 51a. When projected on the X-Y plane, the second portion 41b and the third portion 41c are disposed between the first metal layer end 51a and the second metal layer end 51b.

A direction directed from the first portion 41a to the first end part 41e is an extension direction. A direction parallel to the X-Y plane and parallel to the extension direction is a first direction D1. In this example, the first direction D1 is parallel to the Y-axis direction.

The position of the first end part 41e in the first direction D1 is positioned between the first metal layer end 51a and the second metal layer end 51b.

Further, when projected on the X-Y plane, the first metal layer 51 overlaps at least a part of the first portion 41a. That is, the position of the boundary 41d between the first portion 41a and the third portion 41c in the first direction D1 is positioned between the first metal layer end 51a and the second metal layer end 51b.

For example, the first joint member 61 covers the upper surface 51u of the first metal layer 51. For example, the first joint member 61 contacts the first metal layer end 51a, and contacts the second metal layer end 51b. The first joint member 61 joins the portion between the first metal layer end 51a and the first portion 41a of the first extension part 41. That is, the first joint member 61 includes a first joint portion 61a to join at least a part of a lower surface 41al of the first portion 41a to the first metal layer 51. In this example, the first joint portion 61a contacts the first metal layer end 51a. The first joint portion 61a may contact an end face near the first metal layer end 51a, that is, a side surface of the first joint member 61 on the first joint portion 61a side. The first joint portion 61a further joins a lower surface 41cl of the third portion 41c to the first metal layer 51.

Further, the first joint member 61 joins the second portion 41b to the first metal layer 51. That is, the first joint member 61 further includes a second joint portion 61b to join a lower surface 41bl of the second portion 41b to the first metal layer 51.

Further, the first joint member 61 joins the first end part 41e to the first metal layer 51. That is, the first joint member 61 further includes a third joint portion 61c to join the first end part 41e to the first metal layer 51.

As stated above, the first joint member 61 joins at least the part of the lower surface 41al of the first portion 41a, the lower surface 41bl of the second portion 41b, the lower surface 41cl of the third portion 41c and the first end part 41e to the first metal layer 51.

By this structure, the first extension part 41 and the first metal layer 51 are stably joined. Thereby, high reliability can be obtained.

As described before, the upper end 61cu of the first joint member 61, which contacts the first end part 41e, corresponds to the upper end of the third joint portion 61c of the first joint member 61, which contacts the first end part 41e. The distance in the Z-axis direction between the upper end 61cu of the third joint portion 61c, which contacts the first end part 41e, and the upper surface 51u of the first metal layer 51 is the first height h1. As described before, the first height h1 is 2/3 or more of the thickness T1 of the first extension part 41. There is a case where the shape of the upper end or lower end of the first end part 41e is unstable. Thus, the thickness T1 of the first extension part 41 is made the thickness of the second portion 41b in the Z-axis direction for convenience.

The second height h2 (length of the side surface 61s of the first joint member 61 in the Z-axis direction) described before corresponds to the distance in the Z-axis direction (the second direction D2 perpendicular to the main surface 10u of the ceramic substrate 10) between the lower surface 41al of the first portion 41a and the lower surface 41bl of the second portion 41b.

It is found from experiments that there is an appropriate positional relation between the first extension part 41 and the first metal layer 51 in the Y-axis direction in order to cause the first angle θ1 to be 90 degrees or less and in order to cause the height of the portion of the first end part 41e covered with the first joint member 61 to be 2/3 or more of the thickness of the first extension part 41.

That is, as stated above, in this embodiment, the position of the first end part 41e in the first direction D1 is positioned between the first metal layer end 51a and the second metal layer end 51b. That is, when viewed from the connector part 43, the second metal layer end 51b protrudes from the first end part 41e.

For example, in a reference example in which the position of the second metal layer end 51b in the first direction D1 is arranged between the first end part 41e and the first metal layer end 51a, the first end part 41e is difficult to sufficiently contact with the first joint member 61. Thus, sufficient joint strength can not be obtained.

As in this embodiment, if the position of the first end part 41e in the first direction D1 is arranged between the first metal layer end 51a and the second metal layer end 51b, excellent joining can be obtained.

Further, the protrusion amount of the second metal layer end 51b has an appropriate value.

A length (second length L2) in the first direction D1 between the second metal layer end 51b and the first end part 41e is preferably 0.5 times or more and 3 times or less the thickness T1 of the first extension part 41 (for example, the thickness of the second portion 41b).

If the second length L2 is less than 0.5 times the thickness T1, joining strength of the first joint member 61 (the third joint portion 61c) becomes insufficient. Thus, the joint part is liable to be damaged by, for example, the force when the wiring 80 is inserted into the connector part 43 or the stress generated by heat.

On the other hand, if the second length L2 exceeds 3 times the thickness T1, the material (solder) of the first joint member 61 flows at the time of melting. Thus, it is difficult to achieve that the height of the portion of the first end part 41e covered with the first joint member 61 is 2/3 or more of the thickness of the first extension part 41. That is, if the second length L2 exceeds 3 times the thickness T1, in a formation process of the first joint member 61, in order to obtain the desired shape, the control accuracy of the amount, fluidity or temperature of the first joint member 61 at the time of melting must be made very high. Thus, to obtain the desired shape becomes substantially difficult.

Further, in order to obtain high joint strength, the light reflectivity of the first joint member 61 (for example, solder) can be lower than the reflectivity of the main surface 10u of the ceramic substrate 10. In this case, if the second length L2 is set to be excessively large (for example, larger than 3 times the thickness T1), the reflectivity is excessively reduced.

In this embodiment, the length (the second length L2) in the first direction D1 between the second metal layer end 51b and the first end part 41e is set to be 0.5 times or more and 3 times or less the thickness T1 of the first extension part 41. Accordingly, the high joint strength and high reflectivity can be obtained.

On the other hand, as stated above, in the embodiment, the position of the boundary 41d between the first portion 41a and the third portion 41c in the first direction D1 is arranged between the first metal layer end 51a and the second metal layer end 51b. By this, the first angle θ1 can be easily set to be 90 degrees or less.

For example, if the position of the first metal layer end 51a in the first direction D1 is arranged between the boundary 41d and the second metal layer end 51b, the first angle θ1 becomes 90 degrees or more. In the melted state of the first joint member 61, the lower surface 41bl of the third portion 41b and at least a part of the lower surface 41al of the first portion 41a are covered with the first joint member 61 in the melted state. At this time, the shape of the side surface of the first joint member 61 in the melted state depends on the position of the first metal layer end 51a in the first direction D1. At this time, the first metal layer end 51a is made to protrude toward the connector part 43 side from the boundary 41d where the first extension part 41 is bent. That is, the position of the boundary 41d in the first direction D1 is arranged between the first metal layer end 51a and the second metal layer end 51b. By this, the first angle θ1 can be easily set to be 90 degrees or less.

Further, the protrusion amount of the first metal layer end 51a has an appropriate value.

A length (first length L1) in the first direction D1 between the first metal layer end 51a and the boundary 41d is preferably 0.1 times or more and 1.5 times or less the second height h2. The second height h2 is the distance in the Z-axis direction (second direction D2 perpendicular to the main surface 10u of the ceramic substrate 10) between the lower surface 41al of the first portion 41a and the lower surface 41bl of the second portion 41b.

If the first length L1 is less than 0.1 times the second height h2, for example, even if the amount of the first joint member 61 in the melted state is adjusted, the first angle θ1 is difficult to set to 90 degrees or less. Thus, the joint strength is liable to be insufficient.

If the first length L1 exceeds 1.5 times the second height h2, for example, the first joint member 61 in the melted state flows to cover the first metal layer 51, and for example, the width of the center part of the first joint portion 61a in the height direction becomes narrow, and the joint strength is liable to decrease. If the first length L1 exceeds 1.5 times the second height h2, when heat shock is applied, breakage is liable to occur in the first joint member 61 (and the boundary) by stress due to thermal contraction of the first metal connector 45. That is, highly reliable joining can not be obtained.

In the embodiment, the first length L1 is set to be 0.1 times or more and 1.5 times or less the second height h2. Accordingly, the shape of the first joint member 61 can be easily controlled into such a shape that high reliability can be obtained. Thereby, the high-output and highly reliable light-emitting device can be easily obtained.

For example, a side surface 61cs of the third joint portion 61c at an end of the third joint portion 61c on the opposite side to the first end part 41e is forward tapered. For example, an angle (second angle θ2) between the side surface 61cs of the third joint portion 61c and the lower surface 61l of the first joint member 61 is 5 degrees or more and 60 degrees or less.

For example, an upper portion 61sh of the side surface 61s of the first joint member 61 on the connector part 43 side is forward tapered. That is, an angle (third angle θ3) between the upper portion 61sh of the side surface 61s of the first joint member 61 on the connector part 43 side and the lower surface 41al of the first portion 41a is 5 degrees or more and 60 degrees or less.

For example, in the first direction D1, the first metal layer end 51a is positioned between the boundary 41d and an end 61ae of the first joint member 61 on the connector part 43 side.

For example, in the first direction D1, the end 61ae of the first joint member 61 on the connector part 43 side is positioned between the first metal layer end 51a and the connector part 43.

For example, the thickness T1 of the first extension part 41 (for example, the thickness of the second portion 41b in the Z-axis direction) is 150 µm or more and 300 µm or less.

The first height h1 is 2/3 times or more the thickness T1.

The second height h2 is, for example, 300 µm or more and 1000 µm or less, and is desirably 350 µm or more and 650 µm or less.

The first distance d1 is, for example, 350 µm or more and 1050 µm or less, and is desirably 400 µm or more and 700 µm or less.

The second distance d2 (that is, the distance between the lower surface 41bl of the second portion 41b and the upper surface 51u of the first metal layer 51) is 10 µm or more and 50 µm or less, and is desirably 20 µm or more and 40 µm or less. The second distance d2 corresponds to the thickness of the first joint member 61 (the second joint member 61b) in the Z-axis direction between the lower surface 41bl of the second portion 41b and the upper surface 51u of the first metal layer 51.

The first length L1 is, for example, 50 µm or more and 1000 µm or less, and is desirably 100 µm or more and 300 µm or less.

The second length L2 is, for example, 350 µm or more and 450 µm or less.

The distance (first width w1, see FIG. 3) in the first direction D1 between the end 61ae of the first joint member 61 on the connector part 43 side and the boundary 41d is, for example, 350 µm or more and 550 µm or less.

For example, the minimum value of the distance (for example, a second width w2, see FIG. 3) in the first direction D1 between the third portion 41c and the side surface 61s of the first joint member 61 on the connector part 43 side is 200 µm or more and 400 µm or less. The second width w2 substantially corresponds to the distance in the first direction D1 between the third portion 41c and the side surface 61s on the X-Y plane passing through the center between the upper surface 51u of the first metal layer 51 and the lower surface 41al of the first portion 41a. That is, in the embodiment, for example, the distance between the third portion 41c and the side surface 61s on the X-Y plane passing through the center between the upper surface 51u of the first metal layer 51 and the lower surface 41al of the first portion 41a is 200 µm or more and 300 µm or less.

For example, a distance (for example, a third width w3, see FIG. 3) in the first direction D1 between the boundary 41d and an end 41ba of the second portion 41b on the connector part 43 side is 400 µm or more and 600 µm or less.

By the shape as stated above, the high-output and highly reliable light-emitting device can be obtained.

The structure of the first metal connector 45 can be applied also to the second metal connector 46. By this, with respect to the second connector 46, high reliability can be obtained, and the high-output and highly reliable light-emitting device can be obtained.

### Second Embodiment

This embodiment relates to joining of an electric component 48. A light-emitting device of this embodiment includes the electric component 48 in addition to a ceramic substrate 10, a light-emitting element 20, a metal film 11 and a metal connector 40. In this embodiment, the structure described in the first embodiment can be applied to the ceramic substrate 10, the light-emitting element 20, the metal film 11 and the metal connector 40. In the following, an example of a structure of the electric component 48 will be described.

FIG. 5 is a schematic sectional view exemplifying the light-emitting device of the second embodiment.

FIG. 5 is a schematic sectional view in which a portion of the electric component 48 is enlarged. A first electric component metal layer 55 and a second electric component metal layer 56 are provided on a main surface 10u of the ceramic substrate 10. The second electric component metal layer 56 is separated from the first electric component metal layer 55. The first electric component metal layer 55 and the second electric component metal layer 56 are part of the metal film 11.

The electric component 48 includes a first terminal 48a, a second terminal 48b separated from the first terminal 48a, and an element portion 48c provided between the first terminal 48a and the second terminal 48b. The electric component 48 is, for example, an electrolytic capacitor. In the electric component 48, for example, a package is made of metal. If the package is made of resin, deterioration due to light occurs. The deterioration due to light can be suppressed by using the metal package.

At least a part of the first terminal 48a is arranged on the first electric component metal layer 55. At least a part of the second terminal 48b is arranged on the second electric component metal layer 56. In this example, a direction directed from the first terminal 48a to the second terminal 48b is set to be a Y-axis direction. The Y-axis direction corresponds to a direction directed from the first electric component metal layer 55 to the second electric component metal layer 56.

The first terminal 48a and the first electric component metal layer 55 are joined by a first electric component joint member 65 (for example, solder). The second terminal 48b and the second electric component metal layer 56 are joined by a second electric component joint member 66.

When the electric component 48 is removed, the second electric component metal layer 56 is insulated from the first electric component metal layer 55.

In this embodiment, a length (third height h3) of a portion of the first terminal 48a covered with the first electric component joint member 65 in the Z-axis direction is 2/3 or more of a thickness T2 of the first terminal 48a. A length of a portion of the second terminal 48b covered with the second electric component joint member 66 in the Z-axis direction is 2/3 or more of a thickness of the second terminal 48b. The thickness of the second terminal 48b is, for example, equal to the thickness T2 of the first terminal 48a. For example, the thickness T2 of the first terminal 48a is 5000 µm or more and 10000 µm or less.

A structure similar to that of the first terminal 48a is applied also to the second terminal 48b. By the structure as stated above, when heat shock occurs at the time of operation and the time of blinking, high resistance to thermal stress and high mechanical strength can be obtained. Thereby, stable joining of the electric component 48 can be obtained. By this, the high-output and highly reliable light-emitting device can be obtained.

In this embodiment, an end 48ae of the first terminal 48a is arranged between a one end 55a of the first electric component metal layer 55 in the Y-axis direction and the other end 55b of the first electric component metal layer 55 in the Y-axis direction. The one end 55a is the end of the first electric component metal layer 55 on the element portion 48c side. The other end 55b is the end of the first electric component metal layer 55 on the opposite side to the one end 55a. The end 48ae of the first terminal 48a is the end of the first terminal 48a on the opposite side to the element portion 48c.

A distance (third length L3) in the Y-axis direction between the other end 55b of the first electric component metal layer 55 and the end 48ae of the first terminal 48a is, for example, 500 µm or more and 1000 µm or less. Structures similar to those of the first terminal 48a and the first electric component metal layer 55 can be applied also to the second terminal 48b and the second electric component metal layer 56.

A distance between the first terminal 48a and the first electric component metal layer 55, that is, a thickness of the first electric component joint member 65 provided therebetween is, for example, 15 µm or more and 40 µm or less. Similarly, a distance between the second terminal 48b and the second electric component metal layer 56, that is, a thickness of the second electric component joint member 66 provided therebetween is, for example, 15 µm or more and 40 µm or less.

In this embodiment, the stable joining of the electric component 48 can be obtained, and the high-output and highly reliable light-emitting device can be obtained.

### Third Embodiment

This embodiment relates to a ceramic substrate 10. A light-emitting device of this embodiment includes the ceramic substrate 10, a light-emitting element 20, a metal film 11 and a metal connector 40. In this embodiment, the structure described in the first embodiment can be applied to the light-emitting element 20, the metal film 11 and the metal connector 40. In the following, an example of a structure of the ceramic substrate 10 will be described.

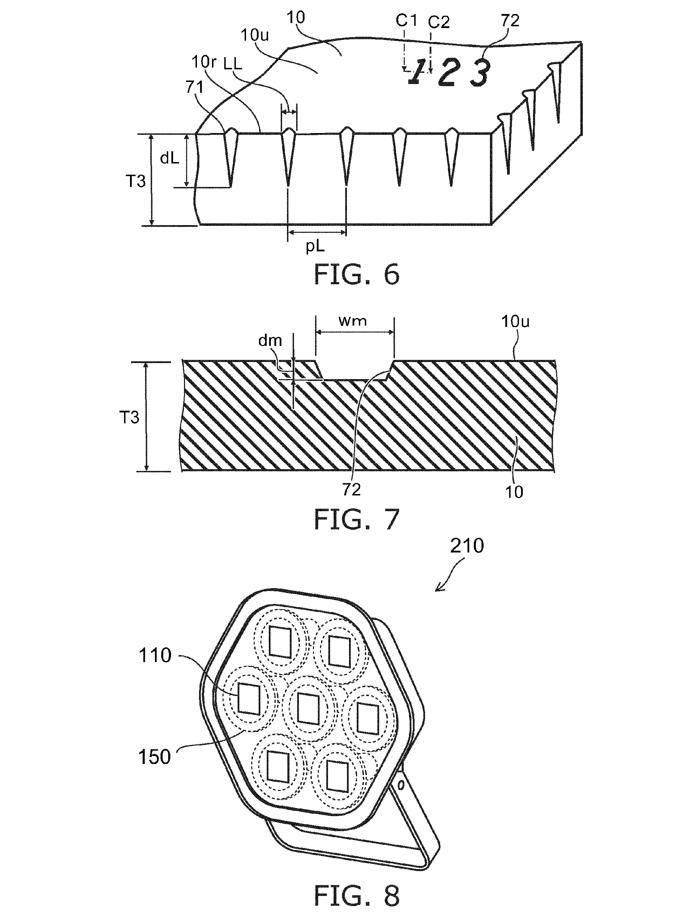

FIG. 6 is a schematic perspective view exemplifying the light-emitting device of the third embodiment.

As shown in FIG. 6, in this embodiment, plural notches 71 are provided along an outer edge 10r of the ceramic substrate 10. For example, the ceramic substrate 10 is formed by dividing a large-area ceramic plate. For example, laser scribing is used for the dividing. Plural spot laser beams are irradiated to the ceramic plate, and plural holes are formed in the ceramic plate. The plural holes are arranged in a shape along the outer edge 10r of the ceramic substrate 10. After the plural holes are formed, stress is applied to the ceramic plate. Thereby, the ceramic plate is divided into plural parts in directions where the plural holes are arranged. Each of the plural divided parts is the ceramic substrate 10.

When the ceramic substrate 10 is formed by the method as stated above, traces of the holes formed in the laser scribing process remain along the outer edge 10r of the ceramic substrate 10. In the dividing of the ceramic plate, since the holes are also divided, the notches 71 are actually formed in the outer edge 10r of the ceramic substrate 10.

As described above, the ceramic substrate 10 of this embodiment is formed by dividing the ceramic plate by using the laser scribing.

In this embodiment, a length LL of each of the plural notches 71 in a direction along the outer edge 10r of the ceramic substrate 10 is 40 µm or more and 60 µm or less. The length LL is a value on a main surface 10u of the ceramic substrate 10.

A depth dL of each of the plural notches 71 is 0.04 times or more and 0.30 times or less a thickness T3 of the ceramic substrate 10. For example, the thickness T3 of the ceramic substrate 10 is about 620 µm or more and 650 µm or less. At this time, the depth dL of each of the plural notches 71 is 220 µm or more and 280 µm or less.

A pitch pL of the plural notches 71 is, for example, 45 µm or more and 55 µm or less.

When the ceramic plate is divided into parts, it is found that according to a condition (diameter, pitch, depth, etc.) of the laser scribing, there is a possibility that a crack occurs from the notch 71 portion formed by the laser scribing. The crack is particularly liable to occur when the temperature of the ceramic substrate 10 and other components become high by, for example, a high-output operation. Further, it is found that the crack is particularly liable to occur when large heat shock is applied by blinking.

The inventor formed samples in which the shape, pitch, depth and the like of the notches 71 formed by laser scribing (that is, the holes formed by the laser) were changed, and performed an operation test and a blinking test of the samples, and found that there was an appropriate condition for the notches 71.

If the length LL of each of the plural notches 71 in the direction along the outer edge 10r of the ceramic substrate 10 is made 40 µm or more and 60 µm or less, the occurrence of the crack can be suppressed.

Further, if the depth dL of each of the plural notches 71 is made 0.04 times or more and 0.30 times or less the thickness T3 of the ceramic substrate 10, the occurrence of the crack can be suppressed while excellent dividing property is obtained. Further, if the pitch of the plural notches 71 is made 45 µm or more and 55 µm or less, the occurrence of the crack can be further suppressed while further excellent dividing property is obtained.

In this embodiment, the ceramic substrate 10 is formed by dividing the ceramic plate into parts. The dividing is performed after, for example, at least one of the light-emitting element 20 and the metal connector 40 is mounted on the ceramic substrate 10. Thereby, high productivity can be obtained. The dividing may be performed before at least one of the light-emitting element 20 and the metal connector 40 is mounted on the ceramic substrate 10.

As exemplified in FIG. 6, there is a case where a groove 72 is provided in the main surface 10u of the ceramic substrate 10. This groove 72 is, for example, a laser mark. A desired symbol or the like can be given to the ceramic substrate 10 by forming the groove 72 having a specified shape. The groove 72 as the laser mark may be provided in the rear surface (surface opposite to the main surface 10u) of the ceramic substrate 10.

### Fourth Embodiment

This embodiment relates to a groove 72 of a ceramic substrate 10. A light-emitting device of this embodiment includes the ceramic substrate 10, a light-emitting element 20, a metal film 11 and a metal connector 40. In this embodiment, the structure described in the first embodiment can be applied to the light-emitting element 20, the metal film 11 and the metal connector 40. In the following, an example of a structure of the groove 72 of the ceramic substrate 10 will be described.

FIG. 7 is a schematic perspective view exemplifying the light-emitting device of the fourth embodiment.

FIG. 7 is a sectional view corresponding to a section taken along line C1-C2 of FIG. 6.

As shown in FIG. 7, the groove 72 is formed in, for example, a main surface 10u of the ceramic substrate 10. The groove 72 is formed by, for example, a CO₂ laser.

A width wm of the groove 72 is, for example, 130 µm or more and 170 µm or less. The width wm of the groove 72 is the width of the groove 72 in a direction perpendicular to an extension direction of the groove 72. If the wall surface of the groove 72 is taper-shaped, the width wm is the width of the groove 72 at an upper end of the groove 72 (that is, a position on the main surface 10u).

On the other hand, a depth dm of the groove 72 is 0.31 times or more and 0.63 times or less a thickness T3 of the ceramic substrate 10. The thickness T3 of the ceramic substrate 10 is, for example, 500 µm or more and 1000 µm or less. If the thickness T3 of the ceramic substrate 10 is about 635 µm, the depth dm of the groove 72 is set to be, for example, 20 µm or more and 40 µm or less.

The occurrence of a crack can be suppressed by the groove 72 as stated above. Thereby, the high-output and highly reliable light-emitting device can be provided.

In this embodiment, since laser is irradiated to the portion of the groove 72, the crystallization of material (for example, aluminum oxide) of the ceramic substrate 10 proceeds. When the crystallization proceeds, the size of crystal grain increases. Thus, the light transmittance of the portion partially becomes high.

As stated above, in the portion of the groove 72 and in the vicinity of the portion of the groove 72, the light transmittance higher than the light transmittance of the other portion can be obtained. The crystal grain size in the portion of the groove 72 and in the vicinity of the portion of the groove 72 is larger than the grain size of the other portion.

The light-emitting device of the first to fourth embodiments can be used as a light source of, for example, a lighting apparatus such as a floodlight.

### Fifth Embodiment

FIG. 8 is a schematic perspective view exemplifying a lighting apparatus of a fifth embodiment.

As shown in FIG. 8, a lighting apparatus 210 of this embodiment includes a light-emitting device described in the foregoing embodiments and a base body 150 connected to the ceramic substrate of the light-emitting device. In this example, the light-emitting device 110 described in the first embodiment is used. In this embodiment, the light-emitting device described in the foregoing embodiments or a modified light-emitting device thereof can be used.

Material, such as metal, having a high thermal radiation property is used for the base body 150. Also in the lighting apparatus 210, the high-output and highly reliable lighting apparatus can be provided.

According to the embodiments, the high-output and highly reliable light-emitting device and lighting apparatus can be provided.

Incidentally, in the specification, the terms "perpendicular" and "parallel" include not only strict meaning of "perpendicular" and "parallel" but also, for example, variations in a manufacturing process, and means "substantially perpendicular" and "substantially parallel".

In the foregoing, the embodiments are described while referring to the specific examples. However, the embodiments are not limited to these specific examples. For example, with respect to the specific structures of the respective components such as the ceramic substrate, the metal layer, the metal connector and the joint member included in the light-emitting device, any structure is included in the scope of the invention as long as a person skilled in the art appropriately selects the structure from a well-known range, the invention is similarly carried out, and the same effects can be obtained.

Besides, a combination of two or more components of the respective specific examples in a technically possible range is also included in the scope of the invention as long as the spirit of the invention is included.

In addition, all light-emitting devices and lighting apparatuses, which can be appropriately designed by a person skilled in the art and can be carried out based on the light-emitting device and the lighting apparatus of the embodiments, are also included in the scope of the invention as long as the spirit of the invention is included.

In addition, within the scope of the concept of the invention, a person skilled in the art can conceive various modifications and corrections, and the modifications and the corrections are also included in the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting device (110) comprising:
a ceramic substrate (10) including a main surface (10u);
a light-emitting element (20) provided on the main surface (10u);
a first metal layer (51) provided on the main surface (10u) and electrically connected to the light-emitting element (20);
a second metal layer (52) separated from the first metal layer (51) on the main surface (10u) and electrically connected to the first metal layer (51);
a metal connector (40) including
a connector part (43) which is provided over the main surface (10u) and is separated from the main surface (10u), and is connected to a wiring through which current supplied to the light-emitting element (20) flows,
a first extension part (41) which extends from one end (43a) of the connector part (43) and at least a part of which is provided on the first metal layer (51), and
a second extension part (42) which extends from the other end (43b) of the connector part (43) and at least a part of which is provided on the second metal layer (52);
a first joint member (61) to join at least the part of the first extension part (41) to the first metal layer (51); and
a second joint member (62) to join at least the part of the second extension part (42) to the second metal layer (52), an angle (θ1) between a lower portion (61sl) of a side surface (61s) of the first joint member (61) on the connector part (43) side and a lower surface (611) of the first joint member (61) in contact with the first metal layer (51) being 90 degrees or less, and
a portion, which has a thickness of 2/3 or more of a thickness (T1) of the first extension part (41), of a first end part (41e) of the first extension part (41) on an opposite side to the connector part (43) being covered with the first joint member (61).

2. The device (110) according to claim 1, wherein
the first extension part (41) includes
the first end part (41e) on the opposite side to the connector part (43),
a first portion (41a) which is provided between the first end part (41e) and the connector part (43), is connected to the connector part (43) and has a first distance (d1) which is a distance from the main surface (10u),
a second portion (41b) which is provided between the first end part (41e) and the first portion (41a) and has a second distance (d2) which is a distance from the main surface (10u) and is shorter than the first distance (d1), and
a third portion (41c) provided between the first portion (41a) and the second portion (41b),
a third angle between a plane parallel to the main surface (10u) and the third portion (41c) is larger than a first angle between the plane and the first portion (41a) and is larger than a second angle between the plane and the second portion (41b),
the first metal layer (51) includes a first metal layer end (51a) on the connector part (43) side and a second metal layer end (51b) on an opposite side to the first metal layer end (51a) when projected on the plane,
a position of the first end part (41e) in a first direction (D1) parallel to the plane and parallel to a direction directed from the first portion (41a) to the first end part (41e) is positioned between the first metal layer end (51a) and the second metal layer end (51b),
a position of a boundary (41d) between the first portion (41a) and the third portion (41c) in the first direction (D1) is positioned between the first metal layer end (51a) and the second metal layer end (51b), and
the first joint member (61) joins at least a part of a lower surface (41al) of the first portion (41a), a lower surface (41bl) of the second portion (41b), a lower surface (41cl) of the third portion (41c) and the first end part (41e) to the first metal layer (51).

3. The device (110) according to claim 2, wherein a length (L1) in the first direction (D1) between the boundary (41d) and the first metal layer end (51a) is 0.1 times or more and 1.5 times or less a distance (h2) in a second direction (D2) perpendicular to the main surface (10u) between the lower surface (41al) of the first portion (41a) and the lower surface (41bl) of the second portion (41b).

4. The device (110) according to claim 2 or 3, wherein a length (L2) in the first direction (D1) between the second metal layer end (51b) and the first end part (41e) is 0.5 times or more and 3 times or less a thickness of the second portion (41b).

5. The device (110) according to any one of claims 2 to 4, wherein a distance (d2) between the second portion (41b) and the first metal layer (51) is 10 µm or more and 50 µm or less.

6. A lighting apparatus (210) comprising:
a light-emitting device (110) according to any one of claims 1 to 5; and
a base body (150) connected to the ceramic substrate (10).
